# EUROPÄISCHE PATENTSCHRIFT

(11) **EP 0 597 873 B1**
(45) Veröffentlichungstag und Bekanntmachung des Hinweises auf die Patenterteilung: **27.09.1995**
(21) Anmeldenummer: 92913510.1
(22) Anmeldetag: 30.06.1992
(51) Int. Cl.: H03H 21/00, H04B 1/12

(54) **VERFAHREN ZUR KOMPENSATION QUASIPERIODISCHER STÖRUNGEN IN MESSIGNALEN**
PROCESS FOR COMPENSATING FOR QUASI-PERIODIC DISTURBANCES OF MEASUREMENT SIGNALS
PROCEDE DE COMPENSATION DE PERTURBATIONS QUASI-PERIODIQUES DE SIGNAUX DE MESURE

(30) Priorität: 09.08.1991 DE 4126463
(43) Veröffentlichungstag der Anmeldung: 25.05.1994
(73) Patentinhaber: SIEMENS AKTIENGESELLSCHAFT, 80333 München (DE)
(72) Erfinder: STROBACH, Peter, D-94133 Röhrnbach (DE)
(86) Internationale Anmeldenummer: DE9200539
(87) Internationale Veröffentlichungsnummer: WO9303544

(56) Entgegenhaltungen:
- US-A- 5 029 118
- IEEE, Seventh Annual Conference of the Engineering in Medicine and Biology Society, 1985, IEEE, (New York, US), A.V. SAHAKIAN et al.: "Canceling the cardiogenic artifact in impedance pneumography", Seiten 855-859
- IEEE Transactions on Biomedical Engineering, Band BME-34, Nr. 1, Januar 1987, (New York, US), N.V. THAKOR: "Adaptive filtering of evoked potentials", Seiten 6-12
- IEEE Transactions on Acoustics, Speech, and Signal Processing, Band ASSP-26, Nr. 5, Oktober 1978, M.R. SAMBUR: "Adaptive noise canceling for speech signals", Seiten 419-423

## Beschreibung

In vielen Bereichen der Meßtechnik und Datenerfassung überlagert sich einem gewünschten Nutzsignal ein unerwünschtes Störsignal. Diese Erscheinung wird im allgemeinen als Interferenz bezeichnet. Häufig ist es nicht möglich, durch geeignete Modifikation der pysikalischen Meßbedingungen eine ausreichende Reduktion der Störsignaleinwirkung zu erreichen. In solchen Fällen versucht man die Interferenz nach der Datenerfassung mit Methoden der adaptiven digitalen Signalverarbeitung im Meßsignal unter Einbeziehung eines Referenzsignals der Störung zu kompensieren (Interferenzkompensation). Eine besondere Schwierigkeit tritt auf, wenn signifikante Anteile der Störung nicht im Referenzsignal enthalten sind. In solchen Fällen versagen die bekannten Verfahren zur adaptiven Interferenzkompensation.

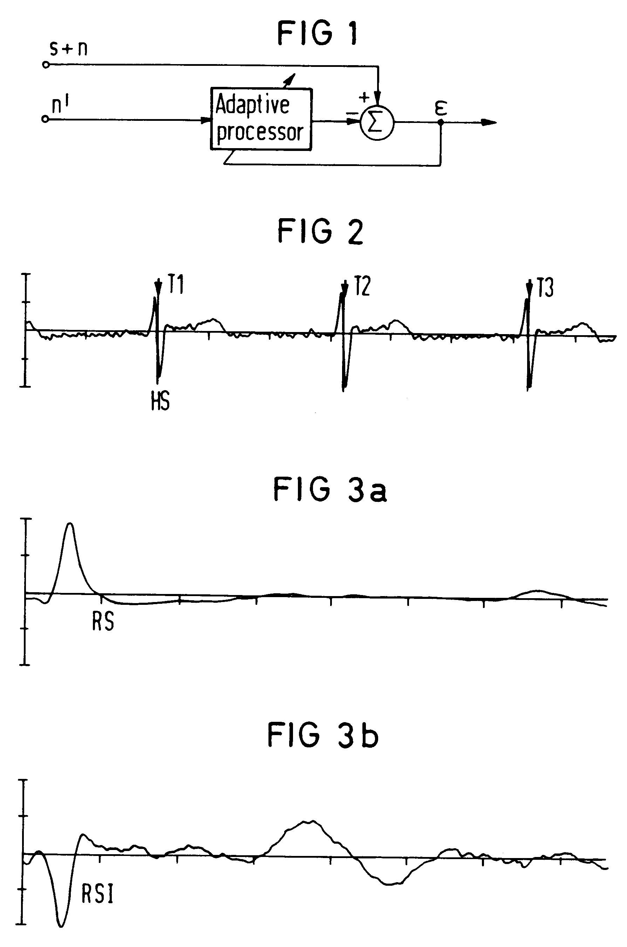

Fig. 1 zeigt in schematischer Weise den bisher bekannten Ansatz zur Interferenzkompensation (B. Widrow und S.D. Stearns: "Adaptive Signal Processing", Prentice-Hall, Englewood Cliffs, NJ, 1985). Bei diesen bekannten Verfahren geht man davon aus, daß eine "Beobachtung" des Störsignals in Form eines Referenzsignals n' vorliegt. Ein adaptives Filter bildet eine lineare oder nichtlineare Kombination einer Anzahl zeitlich aufeinanderfolgender Werte des Referenzsignals n′. Dieses adaptiv vorverarbeitete Referenzsignal wird dann vom gestörten Meßsignal s + n subtrahiert. Die Parameter des linearen oder nichtlinearen adaptiven Filters werden dabei so eingestellt, daß die Energie des Ausgangssignals E ein Minimum annimmt. Damit wird der Störsignalanteil im Ausgangssignal im Sinne der Methode der kleinsten Quadrate minimiert (B. Widrow 1985).

Der hiermit beschriebene klassische Ansatz zur Interferenzkompensation geht von der impliziten Annahme aus, daß sich alle Anteile der Interferenz durch geeignete lineare oder nichtlineare Kompensationen eines Referenzsignals darstellen lassen. Der klassische Ansatz versagt, bzw. liefert unzureichende Kompensationsergebnisse, wenn diese Voraussetzung nicht erfüllt ist, d. h. wenn sich signifikante Anteile der Störung nicht im Referenzsignal abbilden.

Ferner kann der Veröffentlichung von A. V. Sahakian et al: "Cancelling the Cardiogenic Artifact in Impedance Pneumography", IEEE, Seventh Annual Conference of the Engineering in Medicine and Biology Society, 1985, IEEE (New York, US), Seiten 855 bis 859 ein Verfahren zur Gewinnung eines erwünschten Signals (der Atemimpedanzkomponente ZPG) aus einem ankommenden Impedanzsignal, das eine unerwünschte Komponente (ein Störsignal), und zwar die cardiologische Impedanzkomponente (ZCG) enthält, entnommen werden. Das in dieser Schrift beschriebene Verfahren verwendet dabei ebenfalls eine adaptive Filterung. Insbesondere wird in dieser Veröffentlichung vorgeschlagen, ein zum Störsignal korreliertes Hilfssignal (das EKG-Signal) zu verwenden. Dieses korrelierte Hilfssignal ist jedoch von sehr schlechter Qualität, was insbesondere damit zusammenhängt, daß das in dieser Veröffentlichung beschriebene Verfahren die quasiperiodische Charakteristik der Interferenz nicht ausnutzt, um die Qualität des Referenzsignals zu steigern.

In jenen Fällen, in denen das Referenzsignal keine zuverlässige Information über den wahren Verlauf der Interferenz liefert, muß man sich auf anderem Wege eine zuverlässige Information über die Signalform der Interferenz verschaffen. Der Erfindung liegt die Aufgabe zugrunde, für einen Sonderfall der Interferenz, den Fall der sogenannten quasiperiodischen Interferenz, also einem Interferenzsignalverlauf, der sich periodisch wiederholt, wobei sowohl die Periodendauer, als auch die Signalform stochastischen Schwankungen unterworfen sind, ein Verfahren zur Interferenzkompensation anzugeben.

Diese Aufgabe wird durch ein Verfahren zur Trennung eines in einem Meßsignal enthaltenen Nutzsignals von einem ebenfalls in diesem Meßsignal enthaltenen Störsignal mit den Merkmalen nach Anspruch 1 gelöst.

Im Fall einer quasiperiodischen Interferenz verfügt man nämlich meist über ein Hilfssignal aus dem sich die momentane Periodendauer der Interferenz ableiten läßt. Ein solches Hilfssignal läßt sich häufig aus einem weiteren Meßsignal ableiten. In medizintechnischen Anwendungen kann es beispielsweise aus dem EKG oder EEG abgeleitet sein. Bei anderen Anwendungen läßt sich ein solches Hilfssignal unter Umständen durch geeigente Triggerschaltungen aus dem Meßsignal selbst ableiten. Somit sind die Wiederholungszeitpunkte des Interferenzsignals im Meßsignal bekannt. Eine Schätzung des Signalverlaufs der Interferenz erhält man dann durch interferenzsynchrone Mittelung des Meßsignals für den gesamten Meßdatensatz. Die auf diese Weise gewonnene Schätzung des Signalverlaufs einer

Periode der Interferenz wird in einem Referenzspeicher eingetragen. In einer zweiten Phase erfolgt schließlich die adaptive Filterung mit der in Fig. 1 gezeigten Prinzipschaltung, wobei jedoch als Referenzsignal n' der Inhalt des Referenzspeichers dient, aus dem der geschätzte Interferenzsignalverlauf periodisch und interferenzsynchron ausgelesen wird. Das im konventionellen Ansatz direkt in das adaptive Filter (Fig. 1) eingespeiste Referenzsignal liefert bei der erfindungsgemäßen Lösung lediglich die Information über die momentane Periodendauer des Störers. Als gültiges Referenzsignal für die adaptive Filterung dient nun der zyklisch und interferenzsynchron ausgelesene Inhalt des Referenzspeichers.

Bei der Durchführung des Verfahrens wird zunächst aus einem Hilfssignal eine Folge von Triggerzeitpunkten ermittelt und ein Störsignal-Templat geschätzt. Aus diesem Störsignal-Templat wird ein triggersynchrones Referenzsignal erzeugt. Durch adaptive Filterung des Meßsignals mit Hilfe des triggersynchronen Referenzsignals wird schließlich das Nutzsignal vom Störsignal getrennt.

Vorteilhafte Weiterbildungen der Erfindung ergeben sich aus den Unteransprüchen.

In einer bevorzugten Ausführungsform der Erfindung wird das Störsignal-Templat aus dem Meßsignal durch eine triggersynchrone Mittelung des Meßsignals geschätzt. Dabei ist es möglich, die triggersynchrone Mittelung unter Berücksichtigung aller Daten einer Meßreihe nach Abschluß der Meßreihe durchzuführen. Alternativ hierzu ist es ebenso möglich die triggersynchrone Mittelung des Meßsignals während der laufenden Meßreihe durchzuführen. Durch diese Variante des Verfahrens wird das Verfahren auch für Echtzeitanwendung geeignet.

Das Verfahren eignet sich besonders zur Verwendung bei der Filterung medizinischer Meßdaten wie z. B. der Kompensation der Kardiointerferenz bei der Magnetoenzephalographie, wobei das Hilfssignal aus dem Elektrokardiogramm abgeleitet wird.

Ganz allgemein ist es vorteilhaft, das triggersynchrone Referenzsignal aus dem Störsignal-Templat durch eine wiederholte, triggersynchrone Aneinanderreihung des Störsignal-Templates unter Verwendung einer Mischfunktion zur Gewährleistung von Stetigkeitseigenschaften des triggersynchronen Referenzsignales an der Anschlußstelle der Aneindanderreihung zu erzeugen. Bei medizinischen Anwendungen zur Kompensation der Kardiointerferenz bei der Magnetoenzephalographie ist es besonders vorteilhaft, wenn die Anschlußstelle dieser Aneinanderreihung mit einem Zeitpunkt kurz vor der einsetzenden Vorhoferregung zusammenfällt.
- Fig. 1: beschreibt die Struktur eines adaptiven Filters zur Interferenzkompensation.
- Fig. 2: zeigt den zeitliche Verlauf eines typischen Hilfssignales eines quasiperiodischen Störers und die zugehörigen Triggerzeitpunkte.
- Fig. 3: zeigt eine Periode des Referenzsignals und den zugehörigen Inhalt des Referenzspeichers nach 150 triggersynchronen Mittelungen des Meßsignals.
- Fig. 4: zeigt das Prinzip der Erzeugung eines künstlichen Referenzsignals der Interferenz durch triggersynchrone periodische Fortsetzung eines Referenzspeicherinhalts.
- Fig. 5: zeigt schematisch die Generierung eines künstlichen kontinuierlichen Referenzsignals durch wiederholtes Auslesen eines Referenzspeicherinhalts unter Einbeziehung einer linearen Mischfunktion.

Im folgenden wird die Erfindung anhand eines bevorzugten Ausführungsbeispiels sowie mit Hilfe der Figuren näher beschrieben.

Das Verfahren zur Interferenzkompensation kann grundsätzlich in zwei verschiedenen Betriebsweisen durchgeführt werden. Bei einer ersten Verfahrensvariante werden sämtliche Meßdaten der Meßreihe in einem Speicher eines Digitalrechners abgelegt. Neben dem eigentlichen Meßsignal wird ein Hilfssignal HS aufgezeichnet (z. B. ein EKG-Signal), aus der sich die momentane Periodendauer der Störung, bzw. deren Wiederholungszeitpunkte (Triggerzeitpunkte) durch Triggerung ermitteln lassen. Das Verfahren besteht in dieser Variante aus zwei Verfahrensschritten von denen jeder die Abarbeitung des gesamten Datensatzes erfordert.

Im ersten Verfahrensschritt werden durch geeignete Triggerungen (z. B. Schwellwertbildung mit Hilfe eines Schmitt-Triggers) die Wiederholungszeitpunkte des Störsignals aus dem mit aufgezeichneten Hilfssignal HS bestimmt. Gleichzeitig wird das Meßsignal synchron zum Trigger in einem Referenzspeicher aufgemittelt.

Im zweiten Verfahrensschritt wird der Referenzspeicherinhalt synchron mit dem aufgezeichneten Trigger ausgelesen. Auf diese Weise wird ein künstliches Referenzsignal erzeugt. Dieses künstliche Referenzsignal wird zusammen mit den zu entstörenden Meßdaten einem adaptiven Filter zugeführt, welches schließlich die Entstörung durchführt.

Erster Verfahrensschritt:
Fig. 2 zeigt einen typischen Signalverlauf eines Hilfssignals HS für einen quasiperiodischen Störer (beispiel EKG-Signal). Die momentane Periodendauer läßt sich durch ein geeignetes Triggerverfahren aus dem Verlauf dieses Hilfsignals HS bestimmen. Im ersten Verfahrensschritt werden die Triggerzeitpunkte für den gesamten Datensatz bestimmt. Gleichzeitig wird das Meßsignal synchron zum Trigger in einem Referenzspeicher aufgemittelt. Fig. 3 zeigt eine Periode des Referenzsignals RS und den zugehörigen Inhalt des Referenzspeichers RSI nach Aufmittelung von 150 Perioden des Meßsignals. In der Mitte des Referenzspeichers erkennt man deutlich einen sinusähnlichen Signalanteil, der sich im Referenzsignal nicht abbildet. Der Inhalt des Referenzspeichers RSI kann als Schätzung aes wahren Störsignalanteils (Interferenz) im Meßsignal aufgefaßt werden.

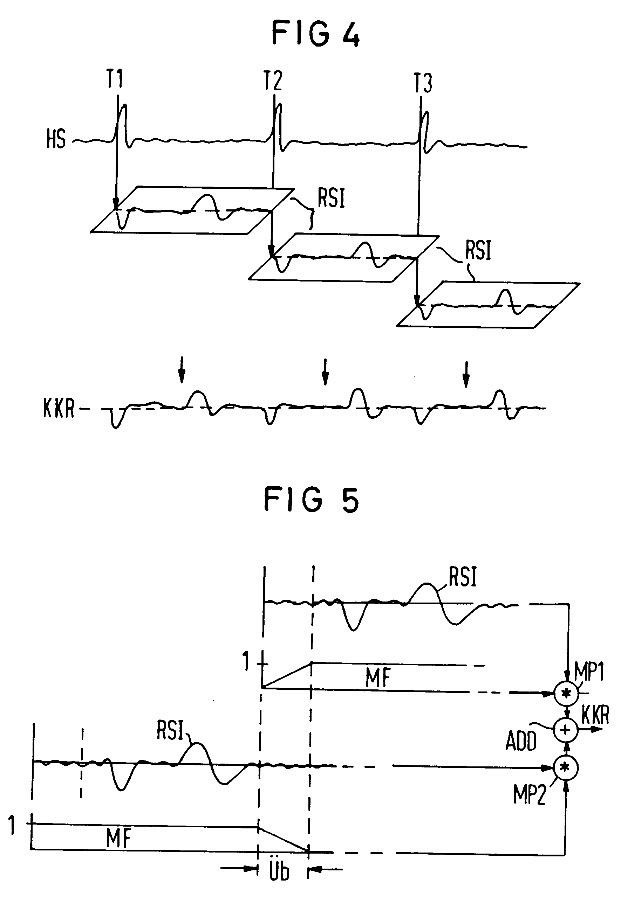

Zweiter Verfahrensschritt:
Im zweiten Verfahrensschritt wird der Referenzspeicherinhalt triggersynchron periodisch fortgesetzt. Fig. 4 verdeutlicht diesen Vorgang der periodischen Fortsetzung des Referenzspeicherinhalts wodurch ein künstliches Referenzsignal erzeugt wird. In jeder Periode ist ein nahtloser Übergang vom Ende zum Anfang des Referenzspeichers zu gewährleisten. Dies wird durch folgende Maßnahmen sichergestellt:
1. Anfang bzw. Ende des Referenzspeichers sollen möglichst mit weitgehend inaktiven Bereichen des gemittelten Meßsignals zusammenfallen.
2. Es ist ein kontinuierlicher Übergang vom Ende zum Anfang des Referenzspeichers zu realisieren (Mischfunktion MF).

Fig. 5 verdeutlicht die Erzeugung eines kontinuierlichen künstlichen Referenzsignals durch wiederholtes Auslesen eines Referenzspeicherinhaltes unter Einbeziehung einer linearen Mischfunktion MF. Das auf diese Weise gewonnene kontinuierliche Referenzsignal wird einem adaptiven Filter zugeführt. An einem zweiten Eingang des adaptiven Filters werden die Meßdaten zugeführt. Das adaptive Filter bildet eine Linearkombination zeitlich aufeinanderfolgender Abtastwerte des Referenzsignals und gleicht damit zeitliche Schwankungen der Interferenz sowie die zeitliche Unsicherheit des Triggers aus. Wie Fig. 5 zeigt, wird die Mischfunktion dabei in der Weise einbezogen, daß der Referenzspeicherinhalt mit der Mischfunktion wie in Fig. 5 dargestellt multipliziert wird. Da die Mischfunktion so beschaffen ist, daß ihre Werte am Ende einer Periode zusammen mit ihren Werten am Anfang der nächsten Periode durch Addition 1 ergeben, wird auf diese Weise eine konvexe Linearkombination der Inhalte des Referenzspeichers durch die in Fig. 5 dargestellte Addition gebildet. Hierdurch wird ein kontinuierlicher Anschluß des Referenzspeicherinhalts beim Übergang von einer Periode auf die nächste Periode gewährleistet.

Eine zweite Variante dieses Verfahens zur Interferenzkompensation bei quasiperiodischen Interferenzen ist nicht für die off line- sondern für die on line-Verarbeitung konzepiert. Es benötigt daher nicht die Aufnahme eines vollständigen Meßdatensatzes und auch nicht zwei getrennte Durchläufe durch die Meßdaten. Statt dessen wird der Inhalt des Referenzspeichers beim Übergang von einer Periode auf die nächste Periode mit Hilfe eines exponentiellen Vergessensfaktors a aktualisiert. a ist ein Faktor dessen Werte sich zwischen 0 und 1 bewegen können, wobei ein typischer Wert etwa 0,99 beträgt. Mit Hilfe dieses exponentiellen Vergessensfaktors berechnet sich der Inhalt eines Speicherelements des Referenzspeichers zur Periode k aus dem Inhalt desselben Referenzspeicherelements zur Periode k - 1 indem dieser ältere Referenzspeicherinhalt zur Periode k - 1 mit dem Faktor a multipliziert wird und zu diesem multiplizierten Wert der momentane Wert des Referenzsignals addiert wird.

Beim Start benötigt das Verfahren eine gewisse Anlaufzeit bis sich eine stabile Schätzung des Interferenzsignalverlaufs im Referenzspeicher aufgebaut hat. Diese Anlaufzeit beträgt typisch 50 bis 100 Perioden des Störsignals.

Das Verfahren kann besonders vorteilhaft zur Kompensation der Kardiointerferenz in Magnetoenzephalogrammen (MEG) angewendet werden. Beim Magnetoenzephalogramm geht es um die Messung einer extrem schwachen Magnetfeldverteilung die durch ein patologisches Zentrum (modelierbar als Stromquelle) im Gehirn eines Patienten erzeugt wird. Die Magnetfeldverteilung wird mit Hilfe eines hochempfindlichen Sensorarrays gemessen, dessen Sensoren die MEG-Meßsignale liefern.

Der durch die patologische Aktivität im Gehirn des Patienten erzeugten Magnetfeldverteilung überlagert sich ein nichtabschrimbares Störfeld welches durch die Herzaktivität des Patienten verursacht wird. Das MEG-Meßsignal kann man sich daher als Überlagerung von drei Signalkomponenten vorstellen:
1. Meßrauschen
2. MEG-Nutzsignal (Folge der zu messenden Magentfeldverteilung)
3. Kardiointerferenz (Folge des quasiperiodischen Wechselfeldes verursacht durch die Herzaktivität des Patienten).

Als Zusatzinformation über die Kardiointerferenz steht das EKG des Patienten zur Verfügung. Aus dem EKG läßt sich durch ein geeignetes Triggerverfahren die momentane Periodendauer der Kardiointerferenz bestimmen. Somit kann das in dieser Erfindungsmeldung beschriebene Verfahren zur Kompensation der Kardiointerferenz eingesetzt werden.

In jedem Falle wird bei beiden Verfahrensvarianten aus einem Hilfssignal eine Folge von Triggerzeitpunkten (T1, T2, T3,...) ermittelt und es wird ein Störsignal-Templat aus dem Meßsignal geschätzt. Dies geschieht vorzugsweise durch eine triggersynchrone Mittelung des Meßsignals. In der einen Verfahrensvariante geschieht diese triggersynchrone Mittelung des Meßsignals unter Berücksichtigung aller Daten einer Meßreihe nach Abschluß der Meßreihe. In einer anderen Verfahrensvariante, welche sich für den Echtzeit oder one-line-Betrieb eignet, geschieht diese triggersynchrone Mittelung des Meßsignals während der laufenden Meßreihe, vorzugsweise indem zu jedem Triggerzeitpunkt ein Zeiger auf Speicherelemente des Referenzspeichers auf den Anfangspunkt dieses Referenzspeichers gesetzt wird, der Inhalt desjenigen Speicherelementes des Referenzspeichers auf welches der Zeiger momentan gesetzt ist mit der Summe aus dem mit einem Faktor multiplizierten momentanen Inhalt dieses Speicherelements und der momentanen Wert des Meßsignals überschrieben wird und der Zeiger anschließend auf ein nachfolgendes Speicherelement des Referenzspeichers gesetzt wird.

Nach der Schätzung des Störsignal-Templates wird aus diesem ein triggersynchrones Referenzsignal KKR erzeugt, welches zur adaptiven Filterung des Meßsignals benutzt wird. Vorzugsweise wird dabei eine lineare Kombination von Werten des triggersynchronen Referenzsignals, deren Koeffizienten adaptiv durch die Minimierung einer Fehlerfunktion bestimmt werden, von dem Meßsignal subtrahiert. Als Fehlerfunktion eigent sich besonders eine gemittelte Differenz aus dem Meßsignal und der linearen Kombination von Werten des triggersynchronen Referenzsignals.

Um die Stetigkeit des triggersynchronen Referenzsignals an den Anschlußstellen zwischen zwei Perioden zu gewährleisten ist es besonders vorteilhaft wenn das triggersynchrone Referenzsignal aus dem Störsignal-Templat durch wiederholte triggersynchrone Aneinanderreihung des Störsignaltemplates unter Verwendung einer Mischfunktion an der Anschlußstelle ÜB der Aneinanderreihung erzeugt wird. Diese wiederholte triggersynchrone Aneinanderreihung des Störsignal-Templates geschieht besonders vorteilhaft, indem zu jedem Triggerzeitpunkt T1, T2, T3,... ein Zeiger auf ein Speicherelement des Referenzspeichers auf einen Anfangspunkt des Referenzspeichers gesetzt wird, der Inhalt des Speicherelements, auf welches der Zeiger momentan gesetzt ist, mit dem zu diesem Speicherelement gehörigen Wert einer Mischfunktion multipliziert wird und der Inhalt eines weiteren Speicherelements, dessen Adresse zur Adresse des Speicherelements auf welches der Zeiger momentan zeigt in einer festen durch einen Off set gegebenen Beziehung steht, mit dem zu diesem weiteren Speicherelement gehörenden Wert derselben Mischfunktion multipliziert wird, die derart mit Werten der Mischfunktion multiplizierten Inhalte der Speicherelemente addiert werden, die Summe als momentanes triggersynchrones Referenzsignal ausgegeben wird, und der Zeiger anschließend auf ein nachfolgendes Speicherelement gesetzt wird.

Die Stetigkeitseigenschaften des triggersynchronen Referenzsignales KKR werden weiterhin verbessert, wenn das Störsignal-Templat derart wiederholt aneinandergereiht wird, daß die Anschlußstelle mit einem inaktiven Bereich des Störsignal-Templates zusammenfällt. Dies ergibt sich insbesondere unter Berücksichtigung der Figuren 3, 4 und 5. Bei Anwendungen des Verfahrens zur Kompensation der Kardiointerferenz in der Magnetoenzephalographie ist es deshalb besonders vorteilhaft, wenn die Anschlußstelle mit einem Zeitpunkt kurz vor der einsetzenden Vorhoferregung zusammenfällt.

## Patentansprüche

1. Verfahren zur Trennung eines in einem Meßsignal enthaltenen Nutzsignals von einem ebenfalls is diesem Meßsignal enthaltenen quasiperiodischen Störsignal, umfassend folgende Schritte:
a) Ermittelung einer Folge von Triggerzeitpunkten aus einem Hilfssignal,
b) Schätzung eines Störsignal-Templates durch triggersynchrone Mittelung des Meßsignals, wobei das Meßsignal oft genug sich selbst überlagert und sein zeitlicher Verlauf gemittelt, also ein repräsentativer Verlauf desselben gewonnen wird,
c) Erzeugung eines triggersynchronen Referenzsignals aus dem Störsignal-Templat,
d) Filterung des Meßsignals mit Hilfe des triggersynchronen Referenzsignals.

2. Verfahren nach Anspruch 1,
bei dem die triggersynchrone Mittelung des Meßsignals unter Berücksichtigung aller Daten einer Meßreihe nach Abschluß der Meßreihe geschieht.

3. Verfahren nach Anspruch 1,
bei dem die triggersynchrone Mittelung des Meßsignals während der laufenden Meßreihe geschieht, in dem
a) zu jedem Triggerzeitpunkt ein Zeiger eines Mittels zur sequentiellen Speicherung des Störsignal-Templates mit einer Vielzahl von Speicherelementen auf einnen Anfangspunkt dieses Speichermittels gesetzt wird,
b) der Inhalt des Speicherelements, auf welches der Zeiger momentan gesetzt ist, mit der Summe aus dem mit einem Faktor multiplizierten momentanen Inhalt dieses Speicherelements und dem momentanen Wert des Meßsignals überschrieben wird, und
c) der Zeiger anschließend auf ein nachfolgendes Speicherelement gesetzt wird.

4. Verfahren nach einem der vorhergehenden Ansprüche,
bei dem das Nutzsignal durch serielle adaptive Filterung des Meßsignals von dem Störsignal getrennt wird.

5. Verfahren nach Anspruch 4,
bei dem eine lineare Kombination von Werten des triggersynchronen Referenzsignals, deren Koeffizienten adaptiv durch die Minimierung einer Fehlerfunktion bestimmt werden, von dem Meßsignal substrahiert wird.

6. Verfahren nach Anspruch 5,
bei dem die Fehlerfunktion eine gemittelte Differenz aus dem Meßsignal und der linearen Kombination von Werten des triggersynchronen Referenzsignals ist.

7. Verfahren nach einem der vorhergehenden Ansprüche,
bei dem das triggersynchrone Referenzsignal aus dem Störsignal-Templat durch wiederholte, triggersynchrone Aneinanderreihung des Störsignal-Templates unter Verwendung einer Mischfunktion zur Gewährleistung von Stetigkeitseigenschaften des triggersynchronen Referenzsignales an der Anschlußstelle der Aneinanderreihung erzeugt wird.

8. Verfahrennach Anspruch 7,
bei dem die wiederholte triggersynchrone Aneinanderreihung des Störsignal-Templates geschieht, in dem
a) zu jedem Triggerzeitpunkt ein Zeiger eines Mittels zur sequentiellen Speicherung des Störsignal-Templates mit einer Vielzahl von Speicherelementen auf einen Anfangspunkt dieses Speichermittels gesetzt wird,
b) der Inhalt des Speicherelements auf welches der Zeiger momentan gesetzt ist, mit dem zu diesem Speicherelement gehörigen Wert einer Mischfunktion multipliziert wird,
c) der Inhalt eines weiteren Speicherelementes, dessen Adresse zur Adresse des Speicherelementes, auf welches der Zeiger momentan zeigt, in einer festen, durch einen Offset gegebenen Beziehung steht, mit dem zu diesem weiteren, Speicherelement gehörenden Wert derselben Mischfunktion multipliziert wird,
d) die derart mit Werten der Mischfunktion multiplizierten Inhalte der Speicherelemente addiert werden,
e) die Summe als momentanes triggersynchrones Referenzsignal ausgegeben wird, und
f) der Zeiger anschließend auf ein nachfolgendes Speicherelement gesetzt wird.

9. Verfahren nach einem der Ansprüche 7 oder 8,
bei dem das Störsignal-Templat derart wiederholt aneinandergereiht wird, daß die Anschlußstelle mit einem inaktiven Bereich des Störsignal-Templates zusammenfällt.

10. Verfahren nach einem der vorhergehenden Ansprüche,
welches zur Kompensation der Kardiointerferenz bei der Magnetoenzephalographie verwendet wird, wobei das Hilfssignal aus einem Elektrokardiogramm abgeleitet wird.

11. Verfahren nach Anspruch 9,
welches zur Kompensation der Kardiointerferenz bei der Magnetoenzephalographie verwendet wird, wobei die Anschlußstelle mit einem Zeitpunkt kurz vor der einsetzenden Vorhoferregung zusammenfällt.

## Claims

1. Process for separating a wanted signal, contained in a measurement signal, from a quasi-periodic disturbing signal, likewise contained in this measurement signal, comprising the following steps:
a) determination of a series of trigger instants from an auxiliary signal,
b) estimation of a disturbing signal template by trigger-synchronous averaging of the measurement signal, the measurement signal being superposed on itself sufficiently frequently and its temporal progression being averaged, i.e. a representative characteristic thereof being obtained,
c) generation of a trigger-synchronous reference signal from the disturbing signal template,
d) filtering of the measurement signal with the aid of the trigger-synchronous reference signal.

2. Process according to Claim 1, in which the trigger-synchronous averaging of the measurement signal takes place with consideration of all the data of a series of measurements after completion of the series of measurements.

3. Process according to Claim 1, in which the trigger-synchronous averaging of the measurement signal takes place while the series of measurements is in progress, by
a) setting at each trigger instant a pointer of a means for sequential storage of the disturbing signal template with a multiplicity of memory elements to a starting point of this storing means,
b) overwriting the content of the memory element to which the pointer is set at that instant with the sum of the instantaneous content of this memory element, multiplied by a factor, and the instantaneous value of the measurement signal, and
c) subsequently setting the pointer to a following memory element.

4. Process according to one of the preceding claims, in which the wanted signal is separated from the disturbing signal by serial adaptive filtering of the measurement signal.

5. Process according to Claim 4, in which a linear combination of values of the trigger-synchronous reference signal, the coefficients of which are determined adaptively by the minimization of an error function, is subtracted from the measurement signal.

6. Process according to Claim 5, in which the error function is an averaged difference from the measurement signal and the linear combination of values of the trigger-synchronous reference signal.

7. Process according to one of the preceding claims, in which the trigger-synchronous reference signal is generated from the disturbing signal template by repeated, trigger-synchronous arrangement in series of the disturbing signal template with use of a mixing function to ensure attributes of constancy of the trigger-synchronous reference signal at the point of connection of the arrangement in series.

8. Process according to Claim 7, in which the repeated trigger-synchronous arrangement in series of the disturbing signal template takes place, by
a) setting at every trigger instant a pointer of a means for the sequential storage of the disturbing signal template with a multiplicity of memory elements to a starting point of this storing means,
b) multiplying the content of the memory element to which the pointer is set at that instant by the value of a mixing function belonging to this memory element,
c) multiplying the content of a further memory element, the address of which is in a fixed relationship, defined by an offset, with the address of the memory element to which the pointer is pointing at that instant, by the value of the same mixing function belonging to this further memory element,
d) adding the contents of the memory elements multiplied by values of the mixing function,
e) outputting the sum as an instantaneous trigger-synchronous reference signal, and
f) subsequently setting the pointer to a following memory element.

9. Process according to one of Claims 7 or 8, in which the disturbing signal template is repeatedly arranged in series in such a way that the point of connection coincides with an inactive region of the disturbing signal template.

10. Process according to one of the preceding claims, which is used for compensating for cardio-interference during magneto-encephalography, the auxiliary signal being derived from an electro-cardiogram.

11. Process according to Claim 9, which is used for compensating for cardio-interference during magneto-encephalography, the point of connection coinciding with a point in time shortly before the atrial stimulation commences.

## Revendications

1. Procédé de séparation d'un signal utile contenu dans un signal de mesure, d'un signal parasite quasi périodique également contenu dans ce signal de mesure, comprenant les étapes suivantes :
a) détermination d'une suite d'instants de déclenchement à partir d'un signal auxiliaire,
b) estimation d'un gabarit du signal parasite en faisant la moyenne, en synchronisme avec les déclenchements, du signal de mesure, le signal de mesure se répétant suffisamment souvent, et on fait la moyenne de sa courbe temporelle, c'est-à-dire que l'on obtient une courbe représentative de celle-ci,
c) production d'un signal de référence qui est en synchronisme avec les déclenchements, à partir du gabarit du signal parasite,
d) filtrage du signal de mesure à l'aide du signal de référence, qui est en synchronisme avec les déclenchements.

2. Procédé suivant le revendication 1, dans lequel on fait la moyenne, en synchronisme avec les déclenchements, du signal de mesure en tenant compte de toutes les données d'une série de mesures, à la fin de la série de mesures.

3. Procédé suivant la revendication 1, dans lequel on fait la moyenne, en synchronisme avec les déclenchements, du signal de mesure dans la série de mesures en cours, dans lequel
a) on positionne, à chaque instant de déclenchement, un pointeur d'un moyen de mémorisation séquentielle du gabarit du signal parasite comportant une multiplicité d'éléments de mémorisation, sur un point initial de ce moyen de mémorisation,
b) on réenregistre dans le contenu de l'élément de mémoire, sur lequel le pointeur est positionné momentanément, la somme du contenu instantané, multipliée par un facteur, de cet élément de mémoire et de la valeur instantanée du signal de mesure, et
c) on positionne ensuite le pointeur sur un élément de mémorisation suivant.

4. Procédé suivant l'une des revendications précédentes, dans lequel on sépare le signal utile du signal parasite par filtrage sériel adaptatif du signal de mesure.

5. Procédé selon la revendication 4, dans lequel on soustrait du signal de mesure une combinaison linéaire de valeurs du signal de référence synchrone des déclenchements, dont on détermine les coefficients de façon adaptative en minimisant une fonction d'erreur.

6. Procédé suivant la revendication 5, dans lequel la fonction d'erreur est une différence prise en moyenne du signal de mesure et de la combinaison linéaire de valeurs du signal de référence synchrone des déclenchements.

7. Procédé suivant l'une des revendications précédentes, dans lequel on produit le signal de référence, qui est en synchronisme avec les déclenchements, à partir du gabarit du signal parasite par mise en file répétée et en synchronisme avec les déclenchements, du gabarit du signal parasite, en utilisant une fonction de mélange destinée à garantir des propriétés de constance du signal de référence synchrone des déclenchements au point de raccordement de la file.

8. Procédé suivant la revendication 7, dans lequel on effectue la mise en file répétée et en synchronisme avec le déclenchement du gabarit du signal parasite, dans lequel
a) on positionne à chaque instant de déclenchement un pointeur d'un moyen de mémorisation séquentielle du gabarit du signal parasite, qui comporte une multiplicité d'éléments de mémorisation, sur un point initial de ce moyen de mémorisation,
b) on multiplie le contenu de l'élément de mémorisation, sur lequel le pointeur est positionné momentanément, par la valeur associée à cet élément de mémorisation, d'une fonction de mélange,
c) on multiplie le contenu d'un autre élément de mémorisation, dont l'adresse est en relation fixe et donnée par un décalage, avec l'adresse de l'élément de mémorisation, que le pointeur indique momentanément, par la valeur, appartenant à cet autre élément de mémorisation, de cette fonction de mélange,
d) on additionne les contenus des éléments de mémorisation, multipliés de cette manière par des valeurs de la fonction de mélange,
e) on fournit la somme en tant que signal instantané de référence, qui est en synchronisme avec les déclenchements, et
e) on positionne ensuite le pointeur sur un élément suivant de mémorisation.

9. Procédé suivant l'une des revendications 7 ou 8, dans lequel on met en file avec répétition le gabarit du signal parasite, de telle sorte que le point de raccordement coïncide avec un domaine inactif du gabarit du signal parasite.

10. Procédé suivant l'une des revendications précédentes, qu'on utilise pour compenser l'interférence cardiaque dans la magnéto-encéphalographie, le signal auxiliaire étant obtenu à partir d'un électrocardiogramme.

11. Procédé suivant la revendication 9, qu'on utilise pour compenser l'interférence cardiaque dans la magnéto-encéphalographie, le point de raccordement coïncidant avec un instant peu avant le commencement de l'excitation d'une oreillette.
